(19) Europäisches Patentamt
European Patent Office
Office européen des brevets

(11) Publication number: **0 405 804 A1**

## EUROPEAN PATENT APPLICATION

(21) Application number: 90306552.2

(22) Date of filing: 15.06.90

(51) Int. Cl.5: **H03M 13/00**, H03M 5/12

(30) Priority: 26.06.89 US 371871

(43) Date of publication of application:
02.01.91 Bulletin 91/01

(84) Designated Contracting States:
FR GB IT NL SE

(71) Applicant: AMERICAN TELEPHONE AND
TELEGRAPH COMPANY
550 Madison Avenue
New York, NY 10022(US)

(72) Inventor: Can, Ahmet Eryaman
RD 3, P.O. Box 596
Branchville, New Jersey 07826(US)

(74) Representative: Watts, Christopher Malcolm
Kelway et al
AT&T (UK) LTD. AT&T Intellectual Property
Division 5 Mornington Roadoadoad
Woodford Green Essex IG8 OTU(GB)

(54) Erasure arrangement for an error correction decoder.

(57) In a decoder receiving error correction coded messages comprising forward error correction symbols including phase shift keyed type signals, each block of received symbols is processed to determine the energy of the component phase shift keyed type signals of each symbol and the average energy of the symbol. The component signal energy of the symbol is compared to a first prescribed threshold and symbols having energy values below the first threshold are marked. the average symbol energy is compared to a second prescribed threshold. Symbols having average energy below the prescribed second threshold are chosen and stored in order of increasing energy. Error positions are selected from the marked and chosen symbols in increasing energy order until a prescribed number is reached.

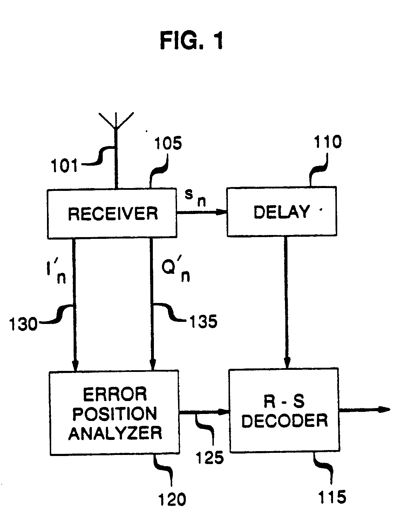

. FIG. 1

EP 0 405 804 A1

# ERASURE ARRANGEMENT FOR AN ERROR CORRECTION DECODER

## Field of the Invention

The invention relates to decoding codes transmitted over error prone channels and more particularly to arrangements for decoding error correction block codes received from a channel subject to fading and other interference.

## Background of the Invention

Digital transmission over radio channels mobile and similar communication is subject to deep and rapidly occurring fades which occur in the transmission channel. Error correction codes well-known in the art such as Reed-Solomon codes have been employed to compensate for channel disruption. Such compensation is achieved by adding redundant bits to blocks of information codes and using the redundant bits to correct errors introduced in the transmission channel. The effectiveness of the error correction arrangement is dependent on the number of added redundant bits. The error correction may be further improved if the location of possible errors in the block are known prior to error correction decoding.

U.S. Patent 4,763,331 issued August 9, 1988 discloses a method for decoding error correcting block codes which decodes a code having redundant bits added to information data bits and transmits the result as an error correcting code. When received, the code is decoded bit by bit to produce a received word and reliability information for respective digits. Reliability information is derived from the electric field level or carrier to noise ratio present for each digit. The received word and each of a plurality of candidate code words are compared and the reliability factor at points of disagreement is summed up to choose the best matching candidate.

U.S. Patent 4,167,701 issued September 11, 1979 discloses a decoder for error-correcting code data which blocks correction of bits received during periods of relatively high signal intensity levels. A syndrome register and decision circuit provide error correcting bits for all bits which the sequence of input data determines to be in error. But only those data bits which occur during low levels of signal intensity are corrected.

U.S. Patent 4,827,489 issued May 2, 1989 discloses a decoding device for digital signals in which every symbol consists of a plurality of binary signals. A first circuit generates a first reliability signal for every binary signal in the symbol and a second circuit generates a second reliability signal for every symbol consisting of n binary signals. Soft decision decoding based on the second reliability signal is effected for every signal. The reliability signals are formed responsive to the signal intensity values.

In the aforementioned patents, error correction capability is improved by using electrical parameters such as carrier to noise ratio or signal intensity to locate the possible errors in a received digital signal. These electrical parameters correspond to channel conditions but do not accurately represent digital symbol fluctuations. The foregoing arrangements also do not consider digital symbol fluctuations where vector type signals are transmitted such as in various types of phase shift keyed coding. It is an object of the invention to provide improved error location in a received digital signal wherein the energy content of the instantaneous digital signals is used to locate possible errors therein.

## Brief Summary of the Invention

The object is achieved by processing each block of received digital symbols to determine the energy of the component signals of each digital symbol and the average energy of the digital symbol. The component signal energies of each symbol are compared to a first prescribed threshold, and the average energy of the symbol is compared to a second prescribed threshold. Symbols having component signal energy below the prescribed threshold are marked and signals having average energies below the second prescribed threshold are stored in order of increasing energy as error locations to be used in error correction decoding so that the number of erasures in each block is optimized.

The invention is directed to an arrangement for decoding digital symbols in which a block of digital symbols is received from a communication channel. Each symbol comprises a sequence of digital codes. Signals representative of the energy of each digital code signal of the symbol and the average digital code signal energy of the symbol are formed. Symbol error positions in the block are located responsive to the block digital code energy signals and the average symbol energy signals.

According to one aspect of the invention, the symbol error position location includes generating a threshold signal corresponding to a prescribed symbol digital code energy level, marking the symbol as a possible error position in the sequence responsive to at least one of the digital code energy signals being less than the energy threshold signal, generating a threshold signal corresponding to a prescribed average symbol energy level, and identifying symbols as possible error positions in the sequence responsive to the marked symbols and to the average energy signal thereof being less than the prescribed symbol bit energy threshold signal.

According to another aspect of the invention, marked symbols and symbols having average energy below the prescribed thresholds are selected as erasure locations in order of increasing energy as error locations to be used in error correction decoding until a prescribed maximum is reached.

According to yet another aspect of the invention, each symbol comprises a sequence of digital codes and each digital code is represented by a a vector signal having a plurality of different phase components. The energy of the vector signal is formed by combining the energies of the different phase components. The vector signal may be a quartenary differential phase shift keyed signal having inphase and quadrature phase components.

## Brief Description of the Drawing

FIG. 1 depicts a general block diagram of an error correction receiver incorporating an error position analyzer illustrative of the invention;

FIG. 2 shows a digital signal processor arrangement that may be used in the error position analyzer of FIG. 1;

FIG. 3 is a flow chart illustrating the general operation of the error position analyzer of FIG. 1; and

FIGS. 4-6 are flowcharts illustrating the operation of the error position analyzer of FIG. 1 in more detail.

## Detailed Description

FIG. 1 is a general block diagram of a receiving and decoding arrangement adapted to receive error correction type codes from a radio channel subject to fading or other interference. Such channels are commonly found in mobile radio systems. The arrangement includes antenna 101, receiver 105, delay 110, Reed-Solomon type decoder 115, and error position analyzer 120. Receiver 105 demodulates an RF signal incorporating error correction codes from antenna 101 to obtain blocks of error correction symbols $s_n$, $n = 1$, 2, ..., N. Each forward error correction (FEC) error coded symbol comprises information bits and parity bits added for error correction. The symbols $s_n$, of each block are passed to Reed-Solomon type decoder 115 wherein the parity bits are used to correct each block of information bits. The error corrected information bits are then available for further processing. Error position analyzer 120 receives signals from receiver 105 in which signals representative of the instantaneous energy of the symbol bits are formed. The bit energy signals are processed to determine symbol positions in the block which are likely to be erroneous. Block error positions are selected and supplied to R-S decoder 115 to improve its error correction operations.

Receiver 105 in FIG. 1 is a quaternary differential phase shift keying (QDPSK) receiver such as described in "Digital Communications" by John G. Prakis published by McGraw Hill Book Company 1983 adapted to demodulate the RF signal from antenna 101 and to convert the phase difference between successive symbol periods into dibits. Other types of modulation may also be used. As is well known in the art, quarternary phase shift keying is a form of phase modulation in which a digital stream is partitioned into dibit symbols 00, 01, 10, and 11. Each dibit symbol corresponds to two bits of information and is encoded on a carrier in the form of an inphase component and a quadrature phase component. The amplitude of the modulated carrier may be constant or shaped to minimize intersymbol interference and each symbol is assigned to a different quadrant of a phase plane.

In a QDPSK arrangement, the difference between successive dibit symbols is encoded as a prescribed phase shift $\pi/4$, $3\pi/4$, $5\pi/4$ or $7\pi/4$ instead of encoding each dibit symbol type as a prescribed phase. A prescribed carrier phase shift of $\pi/4$ indicates no change between successive dibit symbols, e.g., 00, 00. A change such as 00 to 01 is indicated by a carrier phase shift of $3\pi/4$ radians/sec. Similarly, a phase shift of $5\pi/4$ radians/sec results from the sequence 00, 11 and a phase shift of $7\pi/4$ radians/sec is obtained from a 00, 10 sequence. In order to demodulate a received signal, it is only necessary to determine the phase shift from symbol period to symbol period.

The output of receiver 105 is a succession of error correction coded symbols $s_n$. Each symbol has a series of j dibits and each dibit is determined by its inphase component $I'_{nj}$ and its quadrature phase component $Q'_{nj}$. The inphase and quadrature components are also obtained from receiver 105 and are applied to error position analyzer 120. A signal corresponding to the energy of each dibit is generated and used to select block positions that are the most likely to be erroneous. The error correction code symbols of the block are temporarily stored in delay 110 while error position analyzer 120 processes the inphase and quadrature phase components of the block. When the error position analysis is completed, analyzer 120 applies a set of error positions for erasure to R-S decoder 115.

The arrangement of FIG. 1 uses Reed-Solomon block codes of GF (64) for mobile radio channels. Such block codes can cover a wide range of coding rates so that a wide variety of source codes, e.g., data, digital speech, can be reliably protected. As is well known, the GF (64) having a total of N symbols in a block may accommodate any combination of information symbols K and parity symbols N - K as long as

$$N \le 63 . \quad (1)$$

For a given combination of N and K, the total number of correctable symbols

$$t = (N - K)/2 . \quad (2)$$

Two parity symbols are required to correct one error and one parity symbol is needed to correct one erasure. Consequently, the error correction capability of Reed-Solomon codes is increased by providing the possible locations of erroneous symbols to the R-S decoder. If L erasures are assigned because of located erroneous symbols in the block, the number of correctable erroneous symbols is

$$t' = [(N - K) - L]/2 \quad (3)$$

after erasure assignment. The total number of correctable symbols increases to $t = t' + L \quad (4)$
where 0< = L< = N-K.

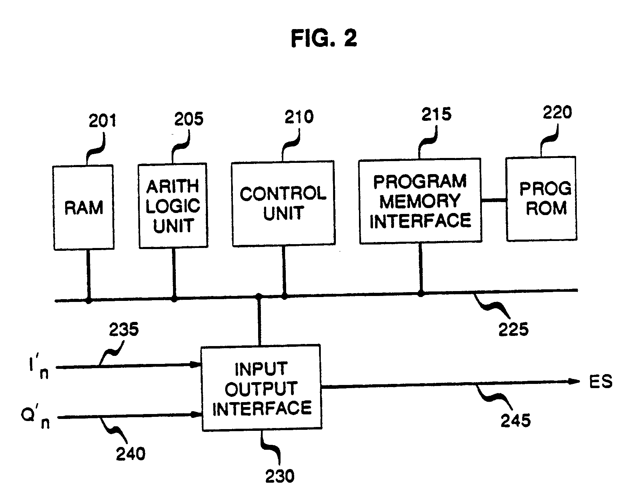

Equation (4) shows that the number of correctable symbols can be doubled if the erasure assignments are correct. According to the invention, erasure assignments are made from a determination of the instantaneous energy values of the error correction code symbols. Error position analyzer 120 may comprise a digital signal processor such as Western Electric type DSP 16 Digital Signal Processor illustrated in the general block diagram of FIG. 2. In FIG. 2, input-output interface 230 receives inphase and quadrature phase components of the successive symbol bits and transfers the components to random access memory 201 via bus 225. Control unit 210 is adapted to carry out the analysis operations in accordance with the instructions stored in program read only memory 220. Control unit 210 coordinates the functions of arithmetic logic unit 205, memory 201, and interface 230 so that erasures for each error correction block are determined and transferred as signals ES to R-S decoder 115 of FIG. 1.

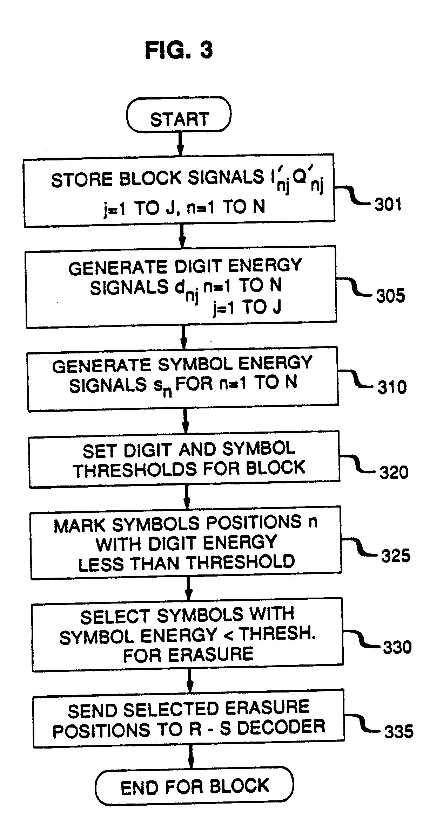

The error analysis performed by the processor of FIG. 2 is illustrated in the general flowchart of FIG. 3. Referring to FIG. 3, the operation of error position analyzer for each block is initiated by storing the inphase component signals $I'_{nj}$ and quadrature phase component signals $Q'_{nj}$ of block of N symbols received from receiver 101 of FIG. 1 (step 301). For a GF (64) code, each error correction symbol comprises j = 3 dibits and has N total symbols. Thus, the sequence of signals applied to the error position analyzer for the nth symbol of an error correction coded block is $I'_{n1}, Q'_{n1} I'_{n2} Q'_{n2} I'_{n3}, Q'_{n3} . \quad (5)$

An energy value $d^2_{nj}$ is produced for each of the j dibits of an error correction code symbol $s_n$ in accordance with

$$d^2_{nj} = I^2_{nj} + Q^2_{nj} \ j = 1, 2, ..., J \text{ and } n = 1, 2, ..., N \quad (6)$$

in step 305. The dibit energy signals $d^2_{nj}$ for each symbol are summed to form a symbol energy representative signal

$$s_n = \sum_{j=1}^{J} d^2_{nj} \qquad\qquad (7)$$

as per step 310. The dibit energy values correspond to the validity of the demodulated information bits in the block while the symbol energy signal is proportional to the average energy of the symbol information bits.

Threshold signals for the dibit and symbol energies are set (step 320) at predetermined levels. The threshold levels may be selected as fixed values $K_d$ and $K_s$ based on previous measurements so that the likelihood of error for dibit or symbol energy below the threshold is high. Alternatively, the dibit threshold $t_d$ may be set to a percentage $\alpha$ of the average dibit energy of the block

4

$$t_d = \alpha \sum_{n=1}^{N} \sum_{j=1}^{J} d_{nj}^2 / NJ \qquad (8)$$

where N is the total number of symbols in the block and J is the total number of dibits in the block. Similarly, the symbol threshold $t_s$ may be set to a percentage $\beta$ of the average symbol energy of the block.

$$t_s = \beta \sum_{n=1}^{N} s_n / N \qquad (9)$$

An adaptive arrangement may be used in which a set value is modified as a function of the average energy over a block. For dibit energy, $t_d$ may be set to

$K_d \pm \Delta K_d \qquad (10)$

where $\Delta K_d = \gamma K_d$ and $\gamma < 1$
so that $t_d$ is decreased by a factory $\gamma$ when the average block energy is decreasing and increased by $\gamma$ when the average block energy is increasing. In like manner, the symbol threshold $t_s$ may be set to

$K_s \pm \Delta K_s \qquad (11)$

whereby $\Delta K_s = \epsilon K_s$ and $\epsilon < 1$.

Once the threshold values are set for the error correction block, the symbols having dibit values below threshold $t_d$ are marked by setting the symbol energies to zero (step 325). Symbols having energy values $s_n$ below symbol threshold $t_s$ are then selected for erasure (step 330). This may be done as will be described in order of increasing symbol energy until a symbol with energy greater than $t_s$ is reached or the maximum number of erasures N-K has been counted. The symbol positions to be erased are then sent to R-S decoder 115 of FIG. 1. In this way, the erasure assignment is a function of the energy values of the demodulated signal components in the block. A block having no or few low energy values results in only a few erasures so that parity bits are reserved for error correction. The number of erasures assigned to a block having many low energy values is limited. In this way, the erasure assignment is dynamically adapted to the individual blocks.

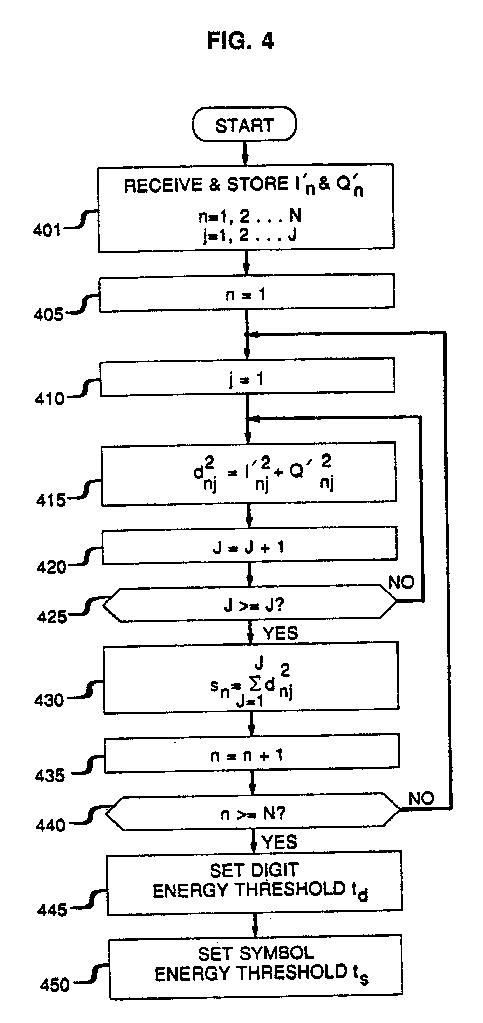

FIG. 4 is a flowchart showing the operations of steps 301, 305, 310 and 320 in greater detail. Referring to FIG. 4, the inphase and quadrature phase components of the block dibits are stored in memory 201 of FIG. 2 in step 401. The symbol index n is set to one (step 405) and the loop including steps 410 through 440 is entered to generate the dibit and symbol energy signals. In step 410, dibit index j is set to one. The energy of dibit j for the current symbol is formed in step 415. Dibit index j is incremented (step 420). Step 415 is reentered from step 425 until j is greater than J. Step 430 is entered after the dibit energies for symbol n have been determined and stored and the symbol energy signal $s_n$ is formed in step 430. Symbol index n is incremented (step 435) and step 410 is reentered via step 440 until the last symbol of the block has been processed. After the dibit and symbol energy signals for the block have been stored, digit energy threshold $t_d$ set as $K_d$ or formed according to equation (8) or (10) (step 445) and symbol energy threshold $t_s$ is set as $K_s$ or formed as aforementioned according to equations (9) or (11) (step 450).

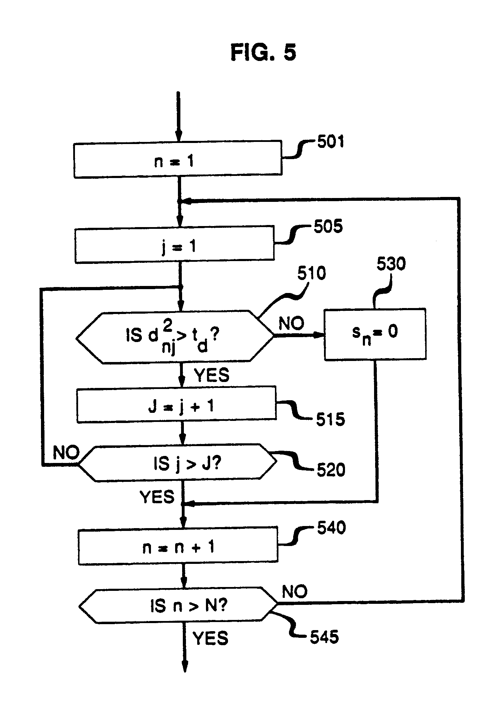

FIG. 5 is a flowchart illustrating the marking of symbols having dibit energy values less than threshold $t_d$ of step 325 of FIG. 3 in greater detail. Step 501 is entered from step 450 of FIG. 4 in which symbol index n is set to one. Dibit index j is reset to one (step 505) and dibit energy $d_{nj}^2$ is compared to dibit threshold $t_d$ in step 510. If $d_{nj}^2$ is greater than dibit threshold $t_d$, dibit index j is incremented (step 515) and comparison step 510 is reentered from step 520. Where all dibits j of symbol n have energy signals greater than the dibit threshold, step 540 is entered from step 520, symbol index n is incremented and the comparison operations for the next symbol are performed. In the event that a dibit energy signal is less than $t_d$ in step 510, the symbol energy $s_n$ is set to zero (step 530). This is done since symbols with dibit energy signals below $t_d$ are the most likely candidates for erasure positions. Symbol index n is then incremented (step 540). When the dibits of the last symbol have been compared to $t_d$, all symbols with possible dibit errors have been marked. It is now possible to select symbol positions for erasure based on symbol energy values.

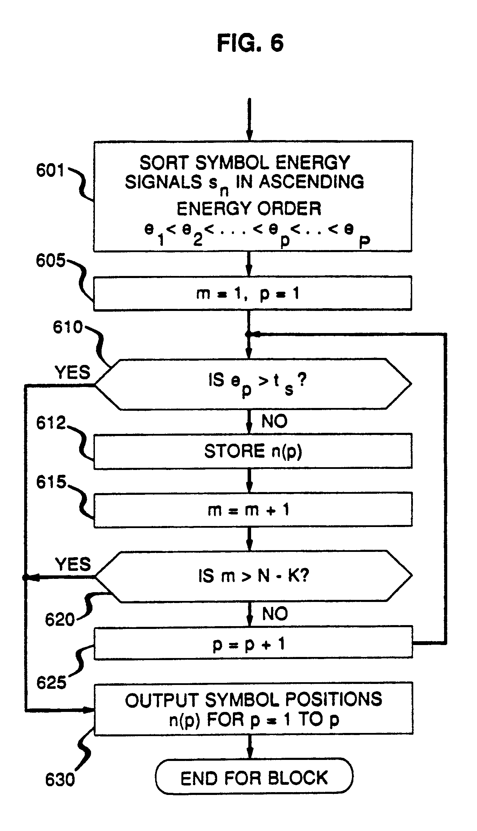

FIG. 6 is a flowchart that illustrates the erasure position selection of step 330 and the erasure position transfer of step 335 in greater detail. In FIG. 6, the symbol energy signals $s_n$ of the block are sorted in ascending order (step 601). Sorting may be done by one of the many arrangements well known in the art such as described in "Numerical Recipes, The Art of Scientific Computing" by W. W. Press, B. P. Flannery, S. A. Teukolsky and W. T. Vetterling published by Cambridge University Press. As a result of the sort operation, the symbols positions n are arranged in order of increasing energy

$$e_1 < e_2 < \cdots < e_p < \cdots < e_P . \quad (12)$$

$e_1$ is the symbol energy of the symbol position having the smallest value $s_n$. $e_P$ is the symbol energy of the symbol position having the largest value $s_n$. The signals $e_p$ are placed in a table in memory 201 of FIG. 2 along with the symbol position $n(p)$ corresponding thereto.

When the sort operations of step 601 are completed, erasure count index $m$ and energy index $p$ are set to one (step 605) and the erasure position selection loop from step 610 to step 625 is entered. In step 610, the sorted energy signal $e_p$ is compared to symbol threshold $t_s$. As long as the $e_p$ signal is less than symbol threshold $s_n$, the erasure position $n(p)$ corresponding to signal $e_p$ is stored (step 612) and the erasure count index $m$ is incremented (step 615). If the erasure count index exceeds the allowable number of erasures N-K, the loop is exited (step 620) and the symbol positions $n(p)$ are output to R-S decoder 115 of FIG. 1 (step 630). Otherwise, index $p$ is incremented (step 625) and step 610 is reentered to test the next $e_p$ energy signal. At some iteration of the selection loop, $e_p$ may become greater than threshold $t_s$ and control is passed to step 630 so that the selected erasure positions $n(p)$ are transferred to the R-S decoder of FIG. 1.

In accordance with the invention, the symbols having dibit energy signals below the dibit threshold $t_d$ are first selected as the most likely error positions. If there are possible erasure positions after selection of these symbol positions, the symbol positions with the least energy signals below the symbol threshold are selected. In any case, the selection operation is adaptive so that only symbols with energy below the threshold are selected in ascending energy order until the maximum number of erasure positions N-K is reached.

## Claims

**1.** Apparatus for decoding an error correction coded signal comprising:
means for receiving a modulated error correction coded signal from a communication channel,
means for demodulating the error correction coded signal to form a block of error correction symbols, each symbol comprising a sequence of digital codes,
CHARACTERIZED BY:
means responsive to the demodulated signal for each digital code for forming a first signal representative of the energy of the demodulated signal corresponding to the digital code,
means responsive to the first signals of each symbol for forming a second signal representative of the energy of the demodulated signals corresponding to the digital code sequence of the symbol, and
means responsive to the first and second signals of the block of symbols for identifying error positions in the block.

**2.** Apparatus for decoding an error correction coded signal from a communication channel according to claim 1 CHARACTERIZED IN THAT each demodulated signal comprises a set of phase components defining a digital code, and the means for forming the first signal comprises means for detecting the phase components of the digital code and means responsive to the phase components of each detected digital code for forming a signal representative of the energy of the demodulated signal for the digital code.

**3.** Apparatus for decoding an error correction coded signal from a communication channel according to claim 2 CHARACTERIZED IN THAT the symbol error position identifying means comprises
means for generating a signal corresponding to a first energy level,
means for generating a signal corresponding to a second energy level,
means responsive to at least one of the first signals of a symbol being less than the first energy level for marking the symbol position, and
means jointly responsive to marked symbol positions and to the second signals of the other symbol positions being less than the second energy level for selecting error positions in the block.

**4.** Apparatus for decoding an error correction coded signal from a communication channel according to claim 3 CHARACTERIZED IN THAT the means for marking symbol positions comprises
means for comparing the first signals of each symbol with the first energy level signal, and
means responsive to the comparison means determining that a first signal of a symbol is less than the first energy level signal for setting the second signal of the symbol to a prescribed value.

**5.** Apparatus for decoding an error correction coded signal from a communication channel according to claim 4 CHARACTERIZED IN THAT the means for selecting symbol positions as error positions in the block comprises
means for sequentially comparing second signals in ascending energy order to the second energy level signal, and
means responsive to each second signal for a symbol being less than the second energy level signal for choosing its symbol position as a possible block error position.

6. Apparatus for decoding an error correction coded signal from a communication channel according to claim 5 CHARACTERIZED IN THAT the symbol position selecting means further comprises

means for determining the maximum number of identified error positions for the block,

means for counting the number of chosen symbol positions after each choosing of a symbol position as a possible block error position, and

means responsive to the number of chosen block error positions reaching the determined maximum for identifying the chosen symbol positions as block error locations.

7. Apparatus for decoding an error correction coded signal from a communication channel according to claim 3 CHARACTERIZED IN THAT the means for generating the first energy level signal further comprises

means responsive to the first signals of each successively received block for forming a signal representative of the average signal energy of the block, and

means responsive to the signal representative of the average signal energy of successively received blocks for modifying the first energy level signal.

8. level for decoding an error correction coded signal from a communication channel according to claim 3 CHARACTERIZED IN THAT the means for generating the second energy level signal further comprises

means responsive to the second signals of each successively received block for forming a signal representative of the average symbol energy of the block, and

means responsive to the signal representative of the average symbol energy of successively received blocks for modifying the second energy level signal.

9. Apparatus for decoding an error correction coded signal from a communication channel according to any of claims 2, 3, 4, 5, 6, 7, or 8 CHARACTERIZED IN THAT the demodulated signal is a quarternary differential phase shift keyed modulated signal having inphase and quadrature phase components, and the means for forming the first signal comprises means for detecting the inphase and quadrature phase components of each digital code of an error correction symbol and means responsive to each detected digital code inphase and quadrature phase components for forming a signal representative of the sum of the squares of the detected inphase and quadrature phase components for the digital code.

10. Apparatus for decoding an error correction coded signal from a communication channel according to claim 9 CHARACTERIZED IN THAT the means for forming the second signal comprises means for summing the signals representative of the sum of the squares of the detected inphase and quadrature phase components of the digital codes of the symbol.

11. A method for decoding an error correction coded signal comprising the steps of:

receiving a modulated error correction coded signal from a communication channel,

demodulating the error correction coded signal to form a block of error correction symbols, each symbol comprising a sequence of digital codes,

CHARACTERIZED BY:

forming a first signal representative of the energy of the demodulated signal corresponding to the digital code responsive to the demodulated signal corresponding to each digital code,

forming a second signal representative of the energy of the demodulated signals corresponding to the digital code sequence of the symbol responsive to the first signals of each symbol, and

identifying error positions in the block responsive to the first and second signals of the block of symbols.

12. A method for decoding an error correction coded signal from a communication channel according to claim 11 CHARACTERIZED IN THAT each demodulated signal comprises a set of phase components defining a digital code, and the step of forming the first signal comprises detecting the phase components of the digital code and forming a signal representative of the energy of the demodulated signal for the digital code responsive to the phase components of the detected digital code.

13. A method for decoding an error correction coded signal from a communication channel according to claim 12 CHARACTERIZED IN THAT the symbol error position identifying step comprises

generating a signal corresponding to a first energy level,

generating a signal corresponding to a second energy level,

marking the symbol positions responsive to at least one of the first signals of a symbol being less than the first energy level, and

selecting error positions in the block jointly responsive to marked symbol positions and to the second signals of the other symbol positions being less than the second energy level.

14. A method for decoding an error correction coded signal from a communication channel according to claim 13 CHARACTERIZD IN THAT the step of marking symbol positions comprises

comparing the first signals of each symbol with the first energy level signal, and

setting the second signal of the symbol to a prescribed value responsive to the comparison means determimhg that a first signal of a symbol is less than the first energy level signal.

**15.** A method for decoding an error correction coded signal from a communication channel according to claim 14 CHARACTERIZED IN THAT the step of selecting symbol positions as error positions in the block comprises

sequentially comparing second signals in ascending energy order to the second energy level signal, and choosing a symbol position as a possible block error position responsive to each second signal for the symbol being less than the second energy level signal.

**16.** A method for decoding an error correction coded signal from a communication channel according to claim 15 CHARACTERIZED IN THAT the symbol position selecting step further comprises

determining the maximum number of identified error positions for the block,

counting the number of chosen symbol positions alter each choosing of a symbol position as a possible block error position, and

identifying the chosen symbol positions as block error locations responsive to the number of chosen block error positions reaching the determined maximum.

**17.** A method for decoding an error correction coded signal from a communication channel according to claim 13 CHARACTERIZED IN THAT the step of generating the first energy level signal further comprises

forming a signal representative of the average signal energy of the block responsive to the first signals of each successively received block, and

modifying the first energy level signal responsive to the signal representative of the average signal energy of the successively received blocks.

**18.** A method for decoding an error correction coded signal from a communication channel according to claim 13 CHARACTERIZED IN THAT the step of generating the second energy level signal further comprises

forming a signal representative of the average symbol energy of the block responsive to the second signals of each successively received block, and

modifying the second energy level signal responsive to the signal representative of the average symbol energy of the successively received blocks.

**19.** A method for decoding an error correction coded signal from a communication channel according to any of claims 12, 13, 14, 15, 16, 17 or 18 CHARACTERIZED IN THAT the demodulated signal a quarternary differential phase shift keyed modulated signal having inphase and quadrature phase components, and the step of forming the first signal comprises detecting the inphase and quadrature phase components of each digital code of an error correction symbol, forming a signal representative of the sum of the squares of the detected in phase and quadrature phase components for the digital code responsive to each detected digital code inphase and quadrature phase components.

**20.** A method for decoding an error correction coded signal from a communication channel according to claim 19 CHARACTERIZED IN THAT the step of forming the second signal comprises summing the signals representative of the sum of the squares of the detected inphase and quadrature phase components of the digital codes of the symbol.

## FIG. 1

## FIG. 2

201
205
210
215
220

| RAM | ARITH LOGIC UNIT | CONTROL UNIT | PROGRAM MEMORY INTERFACE | PROG ROM |

225

235

$I'_n$ →

$Q'_n$ →

INPUT OUTPUT INTERFACE

→ ES

245

240

230

# FIG. 3

```
        ( START )
           │
           ▼
┌──────────────────────────┐
│ STORE BLOCK SIGNALS I'ₙⱼ Q'ₙⱼ │ ─── 301
│   j=1 TO J, n=1 TO N     │
└──────────────────────────┘
           │
           ▼
┌──────────────────────────┐
│  GENERATE DIGIT ENERGY   │
│  SIGNALS dₙⱼ n=1 TO N    │ ─── 305
│            j=1 TO J       │
└──────────────────────────┘
           │
           ▼
┌──────────────────────────┐
│  GENERATE SYMBOL ENERGY  │
│  SIGNALS sₙ FOR n=1 TO N  │ ─── 310
└──────────────────────────┘
           │
           ▼
┌──────────────────────────┐
│   SET DIGIT AND SYMBOL   │
│   THRESHOLDS FOR BLOCK   │ ─── 320
└──────────────────────────┘
           │
           ▼
┌──────────────────────────┐
│  MARK SYMBOLS POSITIONS n │
│    WITH DIGIT ENERGY     │ ─── 325
│   LESS THAN THRESHOLD    │
└──────────────────────────┘
           │
           ▼
┌──────────────────────────┐
│    SELECT SYMBOLS WITH   │
│ SYMBOL ENERGY < THRESH.  │ ─── 330
│       FOR ERASURE        │
└──────────────────────────┘
           │
           ▼
┌──────────────────────────┐
│  SEND SELECTED ERASURE   │
│ POSITIONS TO R - S DECODER│ ─── 335
└──────────────────────────┘
           │
           ▼
    ( END FOR BLOCK )
```

## FIG. 4

**START**

**401** — RECEIVE & STORE $I'_n$ & $Q'_n$
$n = 1, 2 \ldots N$
$j = 1, 2 \ldots J$

**405** — $n = 1$

**410** — $j = 1$

**415** — $d^2_{nj} = I'^2_{nj} + Q'^2_{nj}$

**420** — $J = J + 1$

**425** — $J >= J$?  NO

YES

**430** — $s_n = \sum_{J=1}^{J} d^2_{nj}$

**435** — $n = n + 1$

**440** — $n >= N$?  NO

YES

**445** — SET DIGIT ENERGY THRESHOLD $t_d$

**450** — SET SYMBOL ENERGY THRESHOLD $t_s$

# FIG. 5

$n = 1$ — 501

$j = 1$ — 505

IS $d_{nj}^2 > t_d$? — 510

NO → $s_n = 0$ — 530

YES

$J = j + 1$ — 515

IS $j > J$? — 520

NO

YES

$n = n + 1$ — 540

IS $n > N$? — 545

NO

YES

## FIG. 6

601 — SORT SYMBOL ENERGY SIGNALS $s_n$ IN ASCENDING ENERGY ORDER
$$e_1 < e_2 < \ldots < e_p < \ldots < e_P$$

605 — $m = 1, \quad p = 1$

610 — IS $e_p > t_s$?
YES

NO

612 — STORE n(p)

615 — $m = m + 1$

IS $m > N - K$?
YES

620 — NO

$p = p + 1$

625

630 — OUTPUT SYMBOL POSITIONS n(p) FOR p = 1 TO p

END FOR BLOCK

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | DERWENT ACCESSION NO. 89-038 318, Questel Tele-systems (WPIL) DERWENT PUBLICATIONS LTD., London * Abstract * & SU-A1-1 441 981 (KARPUKIN) -- | 1,11 | H 03 M 13/00 H 03 M 5/12 |
| A | EP - A2/A3 - 0 208 558 (NEC CORPORATION) * Fig. 1; abstract * -- | 1,11 | |
| A | EP - A2 - 0 296 828 (SONY CORPORATION) * Claims 3,4 * -- | 1,11 | |
| A | WO - A1 - 85/02 958 (SONY CORPORATION) * Abstract * -- | 1,11 | |
| D,A | US - A - 4 167 701 (KUKI et al.) * Totality * -- | 1,11 | TECHNICAL FIELDS SEARCHED (Int. Cl.5) H 03 M 13/00 |
| D,A | US - A - 4 763 331 (MATSUMOTO) * Fig. 13,14,21; claims 1,8, 9,12 * -- | 1,11 | |
| D,A | US - A - 4 827 489 (DOI et al.) * Totality * ---- | 1,11 | |

The present search report has been drawn up for all claims

| Place of search | Date of completion of the search | Examiner |
|---|---|---|
| VIENNA | 22-10-1990 | BAUMANN |